# EUROPEAN PATENT SPECIFICATION

(11) **EP 4 028 784 B1**
(45) Date of publication and mention of the grant of the patent: **19.07.2023**
(21) Application number: 20781076.3
(22) Date of filing: 11.09.2020
(51) Int. Cl.: G01R 19/00, G01R 19/25, G01R 23/18, G01R 23/20

(54) **METHOD FOR MEASURING AND DISPLAYING THE AUDIO SIGNAL/NOISE RATIO**
VERFAHREN ZUM MESSEN UND ANZEIGEN DES AUDIO-SIGNAL/RAUSCH-VERHÄLTNISSES
PROCÉDÉ DE MESURE ET D'AFFICHAGE DU RAPPORT SIGNAL/BRUIT AUDIO

(30) Priority: 13.09.2019 IT 201900016328
(43) Date of publication of application: 20.07.2022
(73) Proprietor: Elenos S.r.l., 44028 Poggio Renatico (IT)
(72) Inventor: Busi, Leonardo, 44028 Poggio Renatico (IT) (IT)
(74) Representative: Ruzzu, Giammario
(86) International application number: PCT/IB2020/058469
(87) International publication number: WO 2021/048812

(56) References cited:
- EP-A1- 1 804 388
- CA-A1- 2 298 833
- US-A- 6 021 204
- US-A1- 2008 201 092
- US-A1- 2009 177 423
- US-B1- 6 469 657

## Description

### TECHNICAL FIELD

The present invention belongs to the technical sector relating to radio frequency diffusion systems ("Broadcasting") of signals, for example of radio or television signals and, more precisely, the audio signal, or the audio part of the signal in the case of television broadcasting, transmitted by such systems.

In particular, the invention relates to a method for measuring and displaying the audio signal / noise ratio of a radio program, or the audio channel of a television program.

The signal-to-noise ratio in an audio transmission measures the ratio between the power of the useful signal and the power of the overall noise emitted by the transmission system, and is a parameter of fundamental importance in evaluating the quality of an audio transmission.

The noise associated with an audio transmission is usually given by the sum of two components: the first is the ambient noise, ie that present in the environment in which the recording is made; the second is the system noise, that is the noise introduced by the components of the audio signal acquisition and processing chain, up to its emission in the antenna. The noise sources can be of a thermal nature, that is associated with the motion of the charge carriers in the conductors and in the active components of the system; they can be generated by interference between different transmitted signals; or caused by electrical phenomena generated in the atmosphere. In any case it is a spurious signal of a random nature, which can become annoying if it is not kept below audibility levels.

In every radio and television transmission system, the audio signal / noise ratio is regularly monitored to ensure the quality of the audio signal sent to the antenna.

### BACKGROUND ART

Conventional monitoring methods generally provide for the on-line insertion of test signals, temporally offset from each other. In particular, a reference signal having known characteristics and a mute signal are introduced in sequence, and its output powers are measured. The ratio of the measured powers gives the signal-to-noise ratio for that line.

Measurements can provide an instant signal-to-noise ratio, a ratio given by the average of the measurements over time, and can be made with reference signals of different frequencies, to provide information on the signal-to-noise ratio in different portions of the audio band. Arrangements for measuring and displaying the signal-to-noise ratio of audio signals are known from US2009/177423, EP1804388, US6469657, CA2298833, US2008/201092, and US6021204.

### TECHNICAL PROBLEM

In any case, in order to carry out the measurements described above it is necessary that the transmission system is not operational, in order to be able to insert known signals and perform calculations on them. This constitutes a significant drawback when it is necessary to monitor the quality of an audio transmission in real time, perhaps of a channel active 24 hours a day, as to obtain the measurements it is necessary to interrupt the transmission for a time that depends on the type and accuracy. of the measurements made.

This is usually considered unacceptable, or in any case accepted with great difficulty by those responsible for radio and television broadcasts.

### OBJECTS OF THE INVENTION

The object of the present invention is to propose a method for real-time measurement of the audio signal / noise ratio in a radio and television broadcasting capable of providing precise and continuous information without disturbing the transmission itself and without having to interrupt it during measurements.

Another object of the invention is to propose a method for real-time display of the audio signal / noise ratio in a radio and television broadcast measured as described above.

### SUMMARY OF THE INVENTION

The aforementioned purposes, and others besides, are entirely achieved, in accordance with the content of the claims, by means of a method that allows the measurement and display of the audio signal / noise ratio in a system for radio frequency broadcasting of audio and audio signals. / video, without interrupting the transmission to take measurements. The system includes sections for the acquisition of an audio signal, for the analog and / or digital processing of the signal, for the emission of the same in the antenna and for the reception and decoding of the signal.

The method comprises the following operational steps: taking the audio signal processed by the system in a frequency band for a predefined measurement time period; subjecting the picked up audio signal to an FFT (Fast Fourier Transform) operation, to obtain, instant by instant and for the measurement time period, a signal power spectrum for the entire frequency band considered; for each frequency belonging to the frequency band and for the entire measurement time, detect and store the maximum and minimum power values relating to each frequency considered with "MaxHold" and "MinHold" operations, to obtain corresponding sequences, respectively of maximum and minimum power of the audio signal; for each frequency, obtain the signal / audio noise ratio of the signal as a function of the corresponding values of said sequences of maximum and minimum power.

### BRIEF DESCRIPTION OF THE DRAWINGS

The features of the invention will be evident from the following description of a preferred, although not exclusive, embodiment, in accordance with the claims and with the aid of the attached drawing tables, in which:
- Figure 1 illustrates a block diagram of a possible configuration of a system for radio frequency diffusion of audio signals, to which the method according to the invention is applied;
- Figure 2 illustrates a possible display of the maximum and minimum power locus curves in the measurement frequency band.

### DESCRIPTION OF PREFERRED EMBODIMENTS OF THE INVENTION

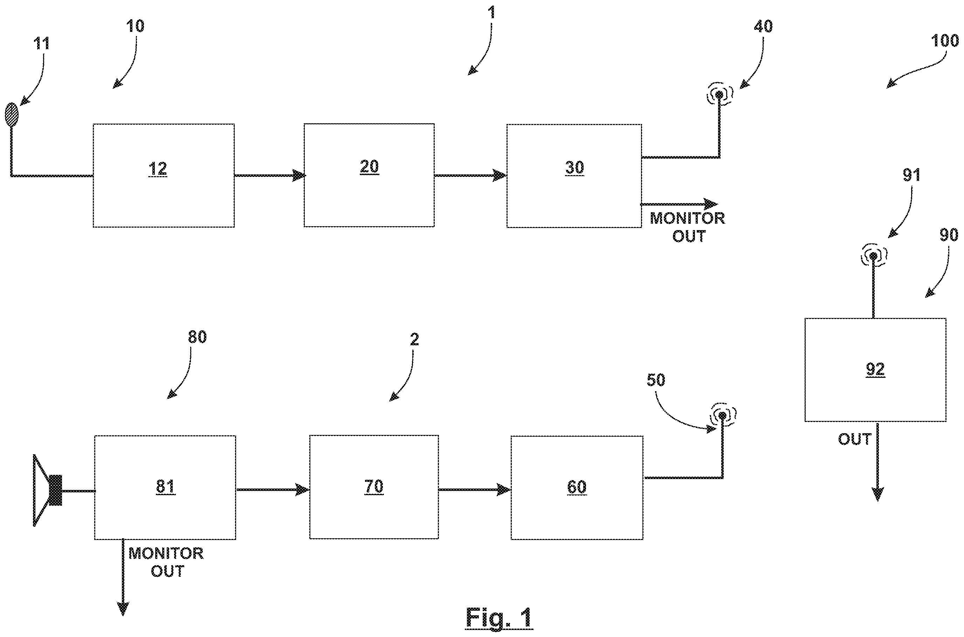

With reference to Figure 1, 100 indicates, as a whole, a system for the broadcasting of audio signals, which may also include means for the radio-frequency broadcasting of video signals. As far as the present invention is concerned, however, in the latter case reference will be made to the audio section of the system.

The system 100, according to known techniques, can acquire and process an audio signal using both analogue and digital technologies.

In a minimal and extremely simplified description for functional blocks, useful only for the purposes of describing the method according to the invention, the system 100 provides a transmitting section 1 and one or more receiving sections 2.

The transmitting section 1 comprises acquisition and encoding means 10 of an audio signal produced in a recording environment, comprising at least one microphone 11 and a preamplifier-encoder apparatus 12. Other known audio inputs of various kinds can also be connected to the latter..

Downstream of the preamplifier-encoder apparatus 12 there is an RF modulator apparatus 20, adapted to convert the low frequency audio signal into a radiofrequency signal, suitably modulated by the audio signal.

Connected to this latter apparatus is an RF power amplifier 30, which in turn supplies the amplified RF signal to a transmitting antenna 40, for broadcasting the signal in the air.

Each of the receiving sections 2 comprises, in a substantially mirrored way, a receiving antenna 50, connected to an RF receiver apparatus 60. The latter is connected to a demodulator / decoder apparatus 70, which returns the audio signal in low frequency, towards a BF 80 output device.

The latter comprises a power amplifier BF 81, to which one or more audio reproduction devices 82 are connected, which may include speakers, audio headphones or the like.

As already mentioned above, each section of the system 100 introduces its own noise component into the audio channel, which adds to the useful signal and the noise already present, which reduces the signal / noise ratio (Y / N) and can also deteriorate significantly the overall signal, reducing its quality. During a high quality audio transmission it is therefore important to monitor the signal / noise ratio as frequently as possible, in order to intervene in the event of exceeding the minimum thresholds considered acceptable.

According to the invention, the method for measuring and displaying the audio signal / noise ratio in the system 100 provides for the continuous or periodic execution of the measurement of the S / N ratio of the audio signal without having to interrupt the audio information flow of the channel.

The method can be advantageously carried out using various apparatuses or groups of apparatuses, known to them, the structure and operation of which are well known by a technician of average experience.

The method provides for the cyclic execution, according to predetermined periods, of a sequence of procedural steps, the first of which involves taking the signal from the audio channel which is to be monitored. The signal is preferably picked up in correspondence with a final processing stage of the system 100 or of a section, transmitter 1 or receiver 2, in such a way as to obtain a measure indicative of the goodness of the diffused audio signal, or of the received one.

In this regard, according to possible different requirements, the signal can be picked up for example at the RF power amplifier 30 of the transmitting section 1, preferably from a monitor output of the same (monitor out); at the power amplifier BF 81 of the receiving section 2, preferably from a monitor output of the same; or "in the field", downstream of the transmitting antenna 40 of the transmitting section 1, by means of a monitoring receiving apparatus 90 which comprises a monitoring antenna 91 and a receiver 92 capable of receiving, demodulating and possibly decoding the audio signal RF, to obtain the BF signal to be analyzed and make it available at the output for sampling.

A single measurement cycle, or T1 measurement time, can have a variable overall duration, depending on specific needs. Basically, a shorter cycle duration means a higher updating frequency of the values of the S / N ratio, with a lower accuracy of the measurement. Quite specularly, a longer T1 measurement time results in higher measurement accuracy, at the expense of the measurement update rate. Typically, but not limitedly, T1 measurement times can be had between 1 second and 5 minutes.

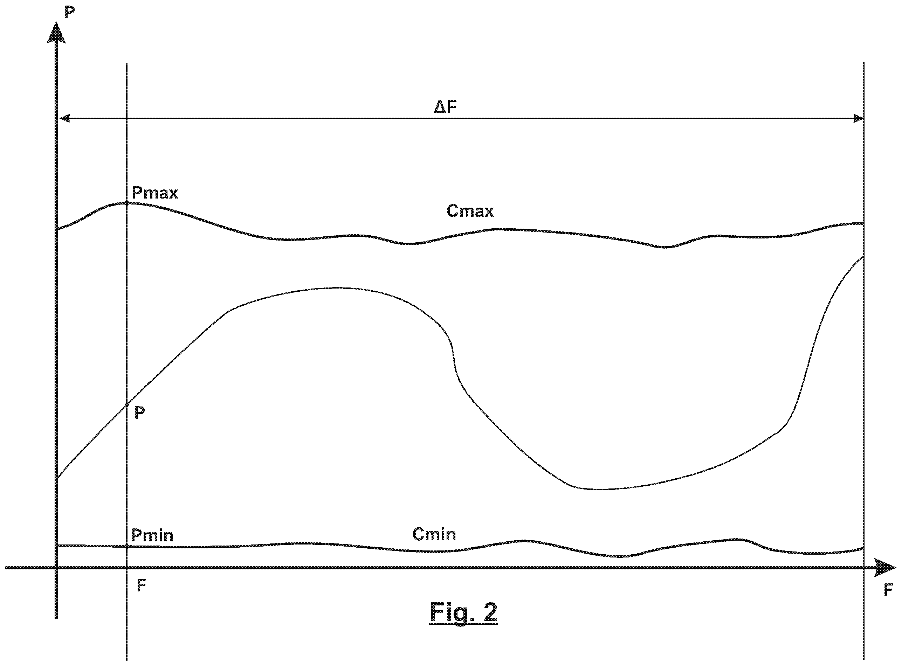

The picked up audio signal (see figure 2) comprises an audio frequency band ΔF which generally belongs to the overall audio band of the system, and preferably contains it all; the signal processing, as will be better detailed in the following, can also be carried out on a higher frequency band (indicatively, for a quality audio transmission, the picked up band can be between 30 and 15,000 Hz).

The next step of the method according to the invention comprises the application to the taken audio signal of an FFT (Fast Fourier Transform) operation, intended to bring the information relating to the signal from the time domain to that of the frequencies. Therefore, for each instant and for the entire measurement time period T1, a signal power spectrum is obtained for the entire frequency band ΔF considered.

In a subsequent phase of the method, for each frequency F belonging to the frequency band ΔF analyzed, and for the entire measurement time T1 chosen, the maximum power values PMax and minimum PMin are detected and stored, with "MaxHold" operations "and" MinHold ". For the entire spectrum of frequencies ΔF, therefore, sequences of maximum power value CMax and minimum CMin are obtained; the values for each single frequency F are updated during the measurement time T1 when new maximum or minimum of the instantaneous power is reached.

For each frequency F the signal / noise ratio S / N is then obtained as a function of the corresponding maximum and minimum values in the aforementioned sequences CMax and CMin, for example as the difference of the respective values expressed in db.

Since the values in the CMax and CMin sequences represent the extreme values reached by the power readings, they can be continuously updated during the T1 measurement time period. The latter must therefore be chosen in such a way as to allow the aforementioned sequences to stabilize sufficiently. Higher T1 periods ensure greater stability and accuracy of the measurement.

The result of the measurement operations, i.e. the values of the sequences of maximum power CMax and minimum power CMin, and the values of the signal / noise ratio S / N over the entire spectrum ΔF considered, is then made available to a user, in the forms deemed most convenient.

The result can, for example, be made available in table format, to allow subsequent processing, or it can be directly subjected to a graphic processing and converted into corresponding curves on a Cartesian reference system (figure 2) and displayed on a monitor, in in order to provide immediate information on the power values of the signal and its quality in terms of S / N ratio.

The values of the sequences of maximum power CMax and minimum CMin relating to each frequency can also be subjected, before their display, to weighing operations, for example as a function of the sensitivity of the human ear in that specific frequency.

The method according to the invention is applied in a similar way in the case of a stereo audio signal. In this case there is a preliminary phase of separation and decoding of the right and left channels of the signal; the phases of calculating the FFT ("Fast Fourier Transform"), storing the maximum power values PMax and minimum PMin, obtaining the corresponding CMax and CMin sequences and obtaining the audio signal / noise ratio values for each mentioned F frequency considered, are made separately for the left and right channels of the stereo signal.

Furthermore, sequences of maximum power values CMax and minimum CMin can be advantageously generated and the corresponding values of the audio signal / noise ratio obtained also for the superimposition of the right and left signal channels.

The results obtained for both channels can be made available both in tabular and graphical form, and displayed on a monitor, as well as for the results obtained for the single channel audio signal.

The method of the invention can also provide for a comparison step of at least one of the maximum power PMax and minimum power PMin values inserted in the sequences of maximum power CMax and minimum power CMin, and of the audio signal / noise ratio S / N , with respective predefined threshold values. If the aforementioned predefined threshold values are exceeded, corresponding alarm information can be sent to a user, local or remote, to allow corrective action to be taken.

In order to ensure the perfect quality of the measurement, known techniques known as SDR (Software Defined Radio) are preferably used in carrying out the method according to the invention. These are fully digitized audio signal processing techniques.

In this case the conversion of the signal from analog to digital takes place immediately after the signal has been entered into the hardware system responsible for carrying out the processing operations, using an A / D converter (Analog-Digital) with at least 16 bits, in order to guarantee a very high precision and a completely transparent operation from the point of view of the introduction of signal quality reduction factors.

In this phase, a band of the digitized signal wider than that of the signal to be analyzed is treated, again digitally within the hardware, by a processor made with FPGA (Field Programmable Data Array) technology which sends it to the software of a computer personal, via a standard connection, such as USB.

The computer software processes the band to be analyzed with appropriate mathematical algorithms that allow, in near real time (typical delays of the order of 200 ms) the filtering, demodulation and decoding of the transmitted radio signal. With the exception of the first A / D conversion phase, the radio is fully implemented using software algorithms.

The software operations that are carried out are translation and filtering of the signal band, demodulation and filtering according to the modulation standard adopted, decoding and filtering if any particular coding exists.

The software then displays and analyzes the signal during the various passages on various screens.

The implementation of the method according to the invention described above makes it possible to advantageously obtain substantially continuous monitoring of the audio signal / noise ratio of a broadcast transmission, for example a radio or radio-television transmission, without absolutely having to cause interruption to the transmission itself, and in an absolutely transparent way for those responsible for the production of the content and the technical managers of the diffusion.

Another advantage produced by the present method is given by the possibility of visually checking, instant by instant, the situation of the audio signal / noise ratio of a transmission being broadcast in the entire signal emission band.

Another advantage is given by the possibility of producing fully automatic alarm information in correspondence with significant drops in the quality of the transmitted audio signal.

However, it is understood that the foregoing has an exemplary and non-limiting value, therefore any detailed changes are considered as of now falling within the protective scope defined by the claims below.

## Claims

1. Method for measuring and displaying the audio signal / noise ratio in a system for radio frequency broadcasting of audio and audio / video signals, said system (100) comprising sections for the acquisition of an audio signal, for the analog and / or digital processing of said signal, of emission of the same in the antenna and of reception and decoding of said signal; said method being **characterized in that** it comprises the following operating steps: taking the audio signal processed by said system (100), in a final processing stage of the same for diffusion, in a frequency band ΔF belonging to the overall audio band of the system (100) and for a predefined measurement time period T1, subjecting said audio signal taken to a Fast Fourier Transform, FFT, operation, to obtain, instant by instant and for said measurement time period T1, a power spectrum of said signal for the entire aforementioned frequency band ΔF considered; for each frequency F belonging to said frequency band ΔF and for the entire aforementioned measurement time T1, detect and store the maximum, PMax, and minimum, PMin, power values relating to each frequency, to obtain corresponding sequences of maximum power, CMax, and minimum power, CMin, respectively of said audio signal; for each said frequency F, obtaining the audio signal / noise ratio, S/N, of said signal as a function of the corresponding values of said sequences CMax and CMin; said measurement time period T1 being such as to allow a substantial stabilization of said sequences CMax and CMin.

2. Method according to claim 1, **characterized in that** said signal to be measured is taken at a final output of the emission section of the aforementioned system for radio frequency diffusion.

3. Method according to claim 2, **characterized in that** said final output is a monitor output of the transmitter apparatus.

4. Method according to claim 1, **characterized in that** said signal to be measured is taken downstream of the transmitting antenna of the aforementioned radio frequency diffusion system, by means of a receiving apparatus (90), suitable for acquiring the signal in the field in different conditions of intensity and quality of the signal generated and diffused by the transmitter apparatus.

5. Method according to claim 1, **characterized in that** said signal to be measured is picked up at a final output of the reception section of the aforementioned radio frequency diffusion system, immediately before the transmission of said audio signal to the end user.

6. Method according to claim 1, **characterized in that** said frequency band ΔF is greater than or equal to the bandwidth of the aforementioned radio frequency signal diffusion system.

7. Method according to claim 1, **characterized in that** said measurement time period T1 is between 1 second and 5 minutes.

8. Method according to claim 1, **characterized in that**, for each cited frequency F of the band ΔF considered, each of said power values, respectively maximum, PMax, and minimum, PMin, is further subjected to weighing operations in function of the sensitivity of the human ear **in that** particular frequency.

9. Method according to claim 1, **characterized in that** said audio signal is a stereo signal, that a preliminary phase of separation and decoding of the right and left channels of said signal is provided, and that said phases of calculation of the FFT, storage of the maximum PMax and minimum PMin power values, obtaining the corresponding sequences CMax and CMin and obtaining the audio signal / noise ratio values S/N for each mentioned frequency F considered, are performed separately for the left and right channels of said stereo signal.

10. Method according to claim 9, **characterized in that** sequences of maximum CMax and minimum CMin power values are also generated and the corresponding values of audio signal / noise ratio S/N obtained also for the superposition of the aforementioned channels left and right signal.

11. Method according to any one of claims 1, 9 and 10, **characterized in that** it comprises a step for providing said sequences of maximum CMax and minimum CMin power values, and of audio signal / noise ratio S/N, in the form of tables.

12. Method according to any one of claims 1, 9 and 10, **characterized in that** it comprises a step for providing said sequences of maximum CMax and minimum CMin power values, and of audio signal / noise ratio S/N, in the form of viewable curves.

13. Method according to claim 11 or claim 12, **characterized in that** it further comprises the display of at least one of said tables or curves on a monitor provided for the purpose.

14. Method according to claim 1, **characterized in that** it also provides a comparison step of at least one of said values of maximum power PMax, minimum power PMin, and audio signal / noise ratio S/N with respective values thresholds, and the emission of corresponding alarm information in case of exceeding the above-mentioned values.

## Patentansprüche

1. Verfahren zum Messen und Anzeigen des Audio-Signal/-Rausch-Verhältnisses in einem System zur Hochfrequenzübertragung von Audio- und Audio/Video-Signalen, wobei das System (100) Abschnitte zum Erfassen eines Audio-Signals, zur analogen und/oder digitalen Verarbeitung des Signals, zur Emission derselben in der Antenne und zum Empfangen und Decodieren des Signals umfasst; wobei das Verfahren **dadurch gekennzeichnet ist, dass** es die folgenden Betriebsschritte umfasst: Nehmen des von dem System (100) verarbeiteten Audio-Signals in einer endgültigen Verarbeitungsstufe derselben zur Diffusion in einem Frequenzband (ΔF), das zu dem gesamten Audioband des Systems (100) gehört, und für eine vordefinierte Messzeitperiode (T1); Unterziehen des zugeführten Audio-Signals einer FFT (Fast Fourier Transform)-Operation, um ein Leistungsspektrum des Signals für jeden Zeitpunkt und für die Messzeitperiode (T1) und für das gesamte oben erwähnte berücksichtigten Frequenzband (ΔF) zu erhalten; für jede Frequenz (F), die zu dem Frequenzband (ΔF) gehört, und für die gesamte vorgenannte Messzeit (T1), das maximale (PMax) und minimale (Pmin) Leistungswerte, die sich auf jede Frequenz beziehen, die mit "MaxHold"-und "MinHold"-Operationen berücksichtigt wird, zu erfassen und zu speichern, um entsprechende Sequenzen maximaler Leistung (Cmax) bzw. minimaler Leistung (Cmin) des Audio-Signals zu erhalten; für jede Frequenz (F) , Erhalten des Audio-Signal/-Rausch-Verhältnisses (S/N) des Signals als eine Funktion der entsprechenden Werte der Sequenzen (CMax) und (CMin); wobei die Messzeitperiode (T1) so ist, dass eine wesentliche Stabilisierung der Sequenzen (CMax) und (CMin) ermöglicht wird.

2. Verfahren nach Anspruch 1, **dadurch gekennzeichnet, dass** das zu messende Signal an einem endgültigen Ausgang des Emissionsabschnitts des vorgenannten Systems zur Hochfrequenzdiffusion genommen wird.

3. Verfahren nach Anspruch 2, **dadurch gekennzeichnet, dass** der Endausgang aus dem "Monitor"-Ausgang der Sendervorrichtung besteht.

4. Verfahren nach Anspruch 1, **dadurch gekennzeichnet, dass** das zu messende Signal der Sendeantenne des vorgenannten Hochfrequenz-Diffusionssystems mittels einer "Ad-hoc"-Empfangsvorrichtung (90) entnommen wird, die geeignet ist, das Signal in dem Feld in unterschiedlichen Bedingungen der Intensität und Qualität des von der Sendervorrichtung erzeugten und diffundierten Signals zu erfassen.

5. Verfahren nach Anspruch 1, **dadurch gekennzeichnet, dass** das zu messende Signal unmittelbar vor der Übertragung des Audio-Signals an den Endbenutzer an einem endgültigen Ausgang des Empfangsabschnitts des vorgenannten Hochfrequenz-Diffusionssystems aufgenommen wird.

6. Verfahren nach Anspruch 1, **dadurch gekennzeichnet, dass** das Frequenzband (ΔF) grösser oder gleich der Bandbreite des vorgenannten System zur Hochfrequenzsignalübertragung ist.

7. Verfahren nach Anspruch 1, **dadurch gekennzeichnet, dass** die Messzeitperiode (T1) zwischen 1 Sekunde und 5 Minuten liegt.

8. Verfahren nach Anspruch 1, **dadurch gekennzeichnet, dass** für jede zitierte Frequenz (F) des betrachteten Bandes (ΔF) jeder der Leistungswerte, jeweils maximale (Pmax) und minimale (Pmin), in Abhängigkeit von der Empfindlichkeit des menschlichen Ohrs in dieser bestimmten Frequenz weiter Wägeoperationen unterzogen wird.

9. Verfahren nach Anspruch 1, **dadurch gekennzeichnet, dass** das Audiosignal ein Stereosignal ist, dass eine vorläufige Phase der Trennung und Decodierung des rechten und linken Kanals des Signals bereitgestellt wird, und dass die Phasen der Berechnung der FFT ("Fast Fourier Transform"), die Speicherung des maximales (PMax) und minimales (Pmin) Leistungswerte, Erhalten der entsprechenden Sequenzen (CMax) und (CMin) und Erhalten der Audio-Signal/ -Rausch Verhältniswerte (S/N) für jede betrachtete Frequenz (F), getrennt für den linken und rechten Kanal des Stereosignals durchgeführt werden.

10. Verfahren nach Anspruch 9, **dadurch gekennzeichnet, dass** auch Sequenzen von maximalen (Cmax) und minimalen (CMin) Leistungswerten erzeugt werden und die entsprechenden Werte des Audio-Signal/-Rausch Verhältnisses (S/N) auch für die Überlagerung der vorgenannten Kanäle links und rechts erhalten werden.

11. Verfahren nach einem der Ansprüche 1, 9 und 10, **dadurch gekennzeichnet, dass** es einen Schritt zum Bereitstellen der Sequenzen von maximalen (Cmax) und minimalen (CMin) Leistungswerten und des Audio-Signal/-Rausch Verhältnisses (S/N) in Form von Tabellen umfasst.

12. Verfahren nach einem der Ansprüche 1, 9 und 10, **dadurch gekennzeichnet, dass** es einen Schritt zum Bereitstellen der Sequenzen von maximalen (Cmax) und minimalen (CMin) Leistungswerten und des Audio-Signal/-Rausch Verhältnisses (S/N) in Form von sichtbaren Kurven umfasst.

13. Verfahren nach Anspruch 11 oder 12, **dadurch gekennzeichnet, dass** es ferner die Anzeige mindestens einer der Tabellen oder Kurven auf einem Monitor umfasst, der für den Zweck vorgesehen ist.

14. Verfahren nach Anspruch 1, **dadurch gekennzeichnet, dass** es auch einen Vergleichsschritt von mindestens einem der Werte maximaler Leistung (Pmax), minimaler Leistung (PMin) und AudioSignal/-Rausch Verhältnis (S/N) mit jeweiligen Werten-Schwellenwerten und die Emission entsprechender Alarminformationen im Falle des Überschreitens der oben genannten Werte bereitstellt.

## Revendications

1. Procédé de mesure et d'affichage du rapport signal/bruit audio dans un système de diffusion radiofréquence de signaux audio et audio/vidéo, ledit système (100) comprenant des sections pour l'acquisition d'un signal audio, pour le traitement analogique et/ou numérique dudit signal, d'émission de celui-ci dans l'antenne et de réception et de décodage dudit signal; ledit procédé étant **caractérisé en ce qu**'il comprend les étapes de fonctionnement suivantes: prendre le signal audio traité par ledit système (100), dans un étage de traitement final de celui-ci pour diffusion, dans une bande de fréquence (ΔF) appartenant à la bande audio globale du système (100) et pendant une période de temps de mesure prédéfinie (T1); soumettre ledit signal audio à une opération FFT (Transformée de Fourier Rapide), pour obtenir, instantané et pour ladite période de temps de mesure (T1), un spectre de puissance dudit signal pour la totalité de la bande de fréquence (ΔF) considérée ; pour chaque fréquence (F) appartenant à ladite bande de fréquence (ΔF) et pour l'ensemble du temps de mesure précité (T1), détecter et stocker les valeurs de puissance maximale (PMax) et minimale (PMin) relatives à chaque fréquence considérée avec des opérations "MaxHold" et " MinHold ", pour obtenir des séquences correspondantes de puissance maximale (CMax) et de puissance minimale (Cmin) respectivement dudit signal audio; pour chaque dite fréquence (F), obtenir le rapport signal/bruit audio (S/N) dudit signal en fonction des valeurs correspondantes desdites séquences (CMax) et (CMin); ladite période de temps de mesure (T1) étant telle qu'elle permet une stabilisation substantielle desdites séquences (CMax) et (CMin).

2. Procédé selon la revendication 1, **caractérisé en ce que** ledit signal à mesurer est pris à une sortie finale de la section d'émission du système précité de diffusion radiofréquence.

3. Procédé selon la revendication 2, **caractérisé en ce que** ladite sortie finale est constituée par la sortie "moniteur" de l'appareil émetteur.

4. Procédé selon la revendication 1, **caractérisé en ce que** ledit signal à mesurer est pris en aval de l'antenne d'émission du système de diffusion radiofréquence précité, au moyen d'un appareil de réception "ad hoc" (90), adapté pour acquérir le signal dans le champ dans différentes conditions d'intensité et de qualité du signal généré et diffusé par l'appareil émetteur.

5. Procédé selon la revendication 1, **caractérisé en ce que** ledit signal à mesurer est capté à une sortie finale de la section de réception du système de diffusion radiofréquence précité, immédiatement avant la transmission dudit signal audio à l'utilisateur final.

6. Procédé selon la revendication 1, **caractérisé en ce que** ladite bande de fréquence (ΔF) est plus grande ou égale à la largeur de bande du système de diffusion de signal radiofréquence précité.

7. Procédé selon la revendication 1, **caractérisé en ce que** ladite période de mesure (T1) est comprise entre 1 seconde et 5 minutes.

8. Procédé selon la revendication 1, **caractérisé en ce que,** pour chaque fréquence (F) citée de la bande (ΔF) considérée, chacune desdites valeurs de puissance, respectivement maximale (PMax) et minimale (PMin) est en outre soumise à des opérations de pesée en fonction de la sensibilité de l'oreille humaine dans cette fréquence particulière.

9. Procédé selon la revendication 1, **caractérisé en ce que** ledit signal audio est un signal stéréo, qu'une phase préliminaire de séparation et de décodage des canaux droit et gauche dudit signal est fournie, et que lesdites phases de calcul de la FFT ("Transformée de Fourier Rapide "), de stockage du maximum (PMax) et des valeurs de puissance minimale (PMin), l'obtention des séquences correspondantes (CMax) et (CMin) et l'obtention des valeurs de rapport signal/bruit audio (S/N) pour chaque fréquence mentionnée (F) considérée, sont effectuées séparément pour les canaux gauche et droit dudit signal stéréo.

10. Procédé selon la revendication 9, **caractérisé en ce que** des séquences de valeurs de puissance maximale (CMax) et minimale (CMin) sont également générées et les valeurs correspondantes de rapport signal/bruit audio (S/N) obtenues également pour la superposition des canaux précités gauche et droit.

11. Procédé selon l'une quelconque des revendications 1, 9 et 10, **caractérisé en ce qu**'il comprend une étape de fourniture desdites séquences de valeurs de puissance maximale (CMax) et minimale (CMin), et de rapport signal/bruit audio (S/N), sous forme de tables.

12. Procédé selon l'une quelconque des revendications 1, 9 et 10, **caractérisé en ce qu**'il comprend une étape de fourniture desdites séquences de valeurs de puissance maximale (CMax) et minimale (CMin), et de rapport signal/bruit audio (S/N), sous la forme de courbes visualisables.

13. Procédé selon la revendication 11 ou la revendication 12, **caractérisé en ce qu**'il comprend en outre l'affichage d'au moins une desdites tables ou courbes sur un moniteur prévu à cet effet.

14. Procédé selon la revendication 1, **caractérisé en ce qu**'il fournit également une étape de comparaison d'au moins l'une desdites valeurs de puissance maximale (PMax), de puissance minimale (PMin) et de rapport signal/bruit audio (S/N) avec des seuils de valeurs respectifs, et de l'émission d'informations d'alarme correspondantes en cas de dépassement des valeurs mentionnées ci-dessus.
